# EUROPEAN PATENT APPLICATION

(11) **EP 1 804 564 A1**
(43) Date of publication of application: **04.07.2007**
(21) Application number: 06077255.5
(22) Date of filing: 14.12.2006
(51) Int. Cl.: H05K 7/20

(54) **Cooling apparatus and method using low fluid flow rates**

(30) Priority: 28.12.2005 US 320123
(71) Applicant: Delphi Technologies, Inc., Troy, Michigan 48007 (US)
(72) Inventor: Visser, Roy A., Greentown, IN 46936 (US)
(74) Representative: Denton, Michael John

(57) **Abstract**

A cooling apparatus 10 including an elongated body portion 12 having a fluid inlet 16, a fluid outlet 18 and a fluid channel 14 extending between the fluid inlet 16 and the fluid outlet 18, wherein the fluid channel 14 includes a generally "G," "C" or "( )" shaped cross-section.

## Description

### TECHNICAL FIELD

The present application relates to apparatus and methods for cooling devices and, more particularly, to apparatus and methods for cooling devices using cooling fluids at low flow rates.

### BACKGROUND OF THE INVENTION

Electronic control modules (ECMs) are used to control electronic fuel injector systems of modem diesel engines. They enable the diesel engines to meet modem pollution standards while enhancing ease of starting, driveability and performance.

Normal operation of an ECM causes a certain amount of heat to be generated by the electronics within the ECM. In some circumstances the generated heat may be dissipated to the air surrounding the ECM. However, oftentimes the ECM is placed in a relatively hot area (e.g., near the engine) or in a location where heat is not easily dissipated, thereby requiring auxiliary cooling.

Liquid coolers have been attached to or included within ECMs to remove the extra heat by circulating various cooling fluids over or through the ECMs. The cooling fluids may be diesel fuel, engine coolant or the like.

One type of diesel fuel cooling/plumbing system utilizes two fluid lines: one line from the fuel tank to the engine and one line from the engine back to the fuel tank. Such systems have the advantage of utilizing high fluid flow rates (i.e., they pass more fuel through the fluid lines than the engine consumes), thereby producing fluid convection behavior that is capable of cooling the ECM without special shapes being as important.

An alternative diesel fuel cooling system utilizes a single fluid line (i.e., one line from the fuel tank to the engine). Such systems operate at much lower fluid flow rates (i.e., typically low-speed laminar flow) and therefore offer less efficient heat transfer. Specifically, such systems operate at fluid flow rates corresponding to the rate of fuel consumption by the engine (e.g., about 0.25 to about 1.5 liters per minute).

Accordingly, there is a need for an apparatus and method for efficiently cooling various devices (e.g., ECMs) using cooling fluids at low flow rates.

### SUMMARY OF THE INVENTION

In one aspect, a cooling apparatus includes an elongated body portion having a fluid inlet, a fluid outlet and a fluid channel extending between the fluid inlet and the fluid outlet, wherein the fluid channel includes at least one of a generally G-shaped cross-section, a generally ( )-shaped cross-section and a generally C-shaped cross-section.

In another aspect, a cooling system includes a heated substrate and a cooling unit connected to the heated substrate, wherein the cooling unit includes an elongated body portion having a fluid inlet, a fluid outlet and a fluid channel extending between the fluid inlet and the fluid outlet, wherein the fluid channel includes at least one of a generally G-shaped cross-section, a generally ( )-shaped cross-section and a generally C-shaped cross-section, and a cooling fluid adapted to move through the fluid channel to cool the heated substrate.

In another aspect, a method for cooling a heated substrate includes the steps of providing a cooling unit having an elongated fluid channel extending therethrough, wherein the fluid channel includes at least one of a generally G-shaped cross-section, a generally ( )-shaped cross-section and a generally C-shaped cross-section, contacting the cooling unit to a substrate and passing a cooling fluid through the fluid channel to cool the substrate.

Other aspects of the cooling apparatus and method will become apparent from the following description, the accompanying drawings and the appended claims.

### BRIEF DESCRIPTION OF THE DRAWINGS

Fig. 1 is a side elevational view of one aspect of a cooling unit of the disclosed cooling apparatus;
Fig. 2 is a side elevational view of a second aspect of the cooling unit of Fig. 1;
Fig. 3 is a side elevational view of a third aspect of the cooling unit of Fig. 1
Fig. 4 is a top plan view of the cooling unit of Fig. 1; and
Fig. 5 is a front perspective view of an ECM having the cooling unit of Fig. 3 attached thereto.

### DESCRIPTION OF THE PREFERRED EMBODIMENTS

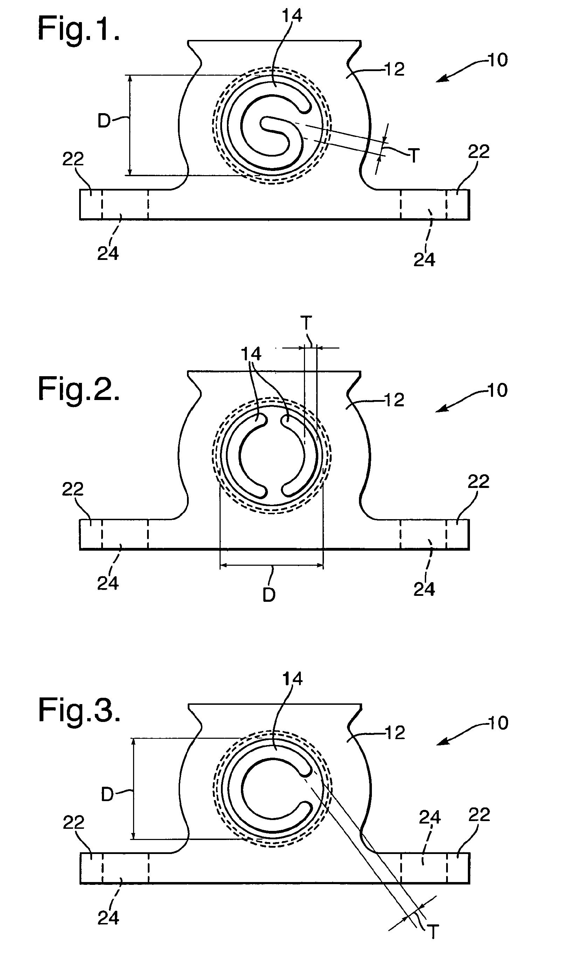

As shown in Figs. 1-4, a cooling unit according to one aspect of the disclosed cooling apparatus and method, generally designated 10, may include an elongated body 12 having a fluid channel (or fluid channels) 14 extending therethrough for receiving a cooling fluid therein. In one aspect, the body 12 may have a length **L** of about 10 to about 100 centimeters. The fluid channel 14 may have a fluid inlet 16 and a fluid outlet 18.

In another aspect, the fluid inlet 16 may be in fluid communication with a fluid source (not shown) such as a fuel tank and the fluid outlet 18 may be in fluid communication with the combustion chamber of an engine (not shown) such that fluid exiting the cooling unit 10 by way of the fluid outlet 18 is passed directly to the engine as fuel. Therefore, the cooling fluid may move though the channel 14 at a relatively low flow rate. In one aspect, the fluid flow rate through the channel 14 may be related to the rate that fuel is consumed by the engine (e.g., about 0.25 to about 1.5 liters per minute).

In another aspect, the unit 10 may be formed from aluminum. However, those skilled in the art will appreciate that the unit 10 may be constructed from various materials (including metals and non-metals) capable of conducting thermal energy without reacting with the cooling fluid. In one aspect, the body 12 and channel 14 may be shaped and formed by an aluminum extruding process.

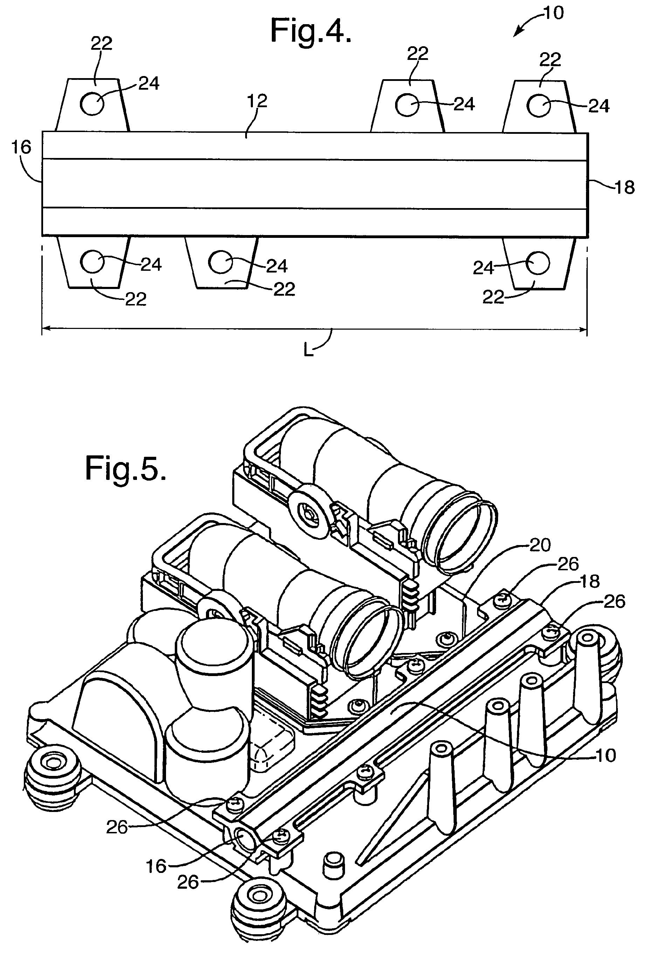

The cooling unit 10 may be provided with an attachment mechanism for securing the cooling unit 10 to a device requiring cooling. For example, as shown in Fig. 3, the cooling unit 10 may be provided with mounting flanges 22 having screw holes 24 therein. As shown in Fig. 4, the cooling unit 10 may be connected to an ECM 20 with screws 26 such that heat generated by the ECM 20 is transferred to the cooling fluid by way of the cooling unit 10. However, those skilled in the art will appreciate that the cooling unit 10 may be connected to a device 20 by any technique or combination of techniques known in the art, including thermal adhesives, welding, rivets, bolts or the like.

As shown in Fig. 1, the fluid channel 14 may be generally G-shaped in end view. In another aspect, as shown in Fig. 2, the fluid channel 14 may be generally ( )-shaped (i.e., closed parenthesis shaped) in end view. In another aspect, as shown in Fig. 3, the fluid channel 14 may be generally C-shaped in end view.

In one aspect, the channel 14 may have an overall cross-sectional diameter **D** of about 10 to about 40 millimeters and the channel 14 may have a cross-sectional thickness **T** of about 1 to about 30 millimeters. The generally G-shaped or generally C-shaped channels may be one continuous channel in cross-section or two or more separate channels in cross-section. The generally ( )-shaped channel may be two or more separated channels in cross-section.

Without being limited to any particular theory, it is believed that the "G," "C" and "( )" shaped channels offer improved heat transfer at low, laminar flow rates due to the low thermal resistance and reduced back pressure achieved by the "G," "C" and "( )" geometries. In particular, it is believed that the "G," "C" and "( )" geometries minimize thermal resistance by maximizing the internal surface area (i.e., the flux area) of the channel 14 while minimizing the boundary layer thickness (i.e., the flow gap width) of the unit 10. Furthermore, it is believed that the "G," "C" and "( )" geometries minimize backpressure by maximizing the cross-sectional flow area of the unit 10, while eliminating sharp corners and intersections.

### EXAMPLES

Two cooling units were prepared as described above using an aluminum extruding process. Each unit was approximately 0.22 meters long. The first unit incorporated a channel having a G-shaped geometry and the second unit incorporated a channel having a ( )-shaped geometry. Each channel had a thickness of about 1.52 mm and an overall diameter of about 14.5 mm. The thermal resistance and backpressure of each unit was determined at various flow rates using mineral oil as the cooling fluid to safely simulate #2 diesel fuel. The results are set forth in Table 1 for the G-shaped channel and Table 2 for the ( )-shaped channel.

**Table 1**

| **Flow Rate (l/min.)** | **Thermal Resistance (°C/Watt)** | **Backpressure (psi)** |
|---|---|---|
| 0.25 | 0.204 | 0.05 |
| 0.5 | 0.174 | 0.095 |
| 1 | 0.144 | 0.19 |
| 1.5 | 0.126 | 0.28 |

**Table 2**

| **Flow Rate (l/min.)** | **Thermal Resistance (°C/Watt)** | **Backpressure (psi)** |
|---|---|---|
| 0.25 | 0.215 | 0.07 |
| 0.5 | 0.184 | 0.13 |
| 1 | 0.154 | 0.26 |
| 1.5 | 0.136 | 0.4 |

Accordingly, cooling units having generally G-shaped and generally ( )-shaped cross-sectional geometries may provide improved heat transfer at low, laminar flow rates.

Although the cooling apparatuses and methods are shown and described with respect to certain aspects, modifications may occur to those skilled in the art upon reading the specification. The cooling apparatuses and methods are limited only by the scope of the claims.

## Claims

1. A cooling apparatus 10 comprising:
an elongated body portion 12 having a fluid inlet 16 and a fluid outlet 18; and
a fluid channel 14 extending between said fluid inlet 16 and said fluid outlet 18, wherein said fluid channel 14 includes at least one of a generally G-shaped cross-section, a generally C-shaped cross-section and a generally ( )-shaped cross-section.

2. The cooling apparatus 10 of claim 1 wherein said elongated body portion 12 is made of extruded aluminum.

3. The cooling apparatus 10 of claim 1 wherein said elongated body portion 12 is about 10 to about 100 centimeters in length.

4. The cooling apparatus 10 of claim 1 wherein said fluid inlet 16 is adapted to be placed in fluid communication with a fuel tank.

5. The cooling apparatus 10 of claim 1 wherein said fluid outlet 18 is adapted to be placed in fluid communication with a combustion chamber of an engine.

6. The cooling apparatus 10 of claim 1 further comprising at least one attachment mechanism 22.

7. The cooling apparatus 10 of claim 1 wherein said fluid channel 14 has an overall cross-sectional diameter of about 10 to about 40 millimeters.

8. The cooling apparatus 10 of claim 1 wherein said fluid channel 14 has a thickness of about 1 to about 30 millimeters.

9. A cooling system comprising:
a heated substrate 20;
a cooling unit 10 adapted to be mounted on said heated substrate 20, wherein said cooling unit 10 includes an elongated body portion 12 having a fluid inlet 16 and a fluid outlet 18 and a fluid channel 14 extending between said fluid inlet 16 and said fluid outlet 18, wherein said fluid channel 14 includes at least one of a generally G-shaped cross-section, a generally C-shaped cross-section and a generally ( )-shaped cross-section; and
a cooling fluid adapted to move through said fluid channel 14 to cool said heated substrate 20.

10. The system of claim 9 wherein said heated substrate 20 is an electronic control module.

11. The system of claim 10 wherein said cooling fluid is diesel fuel.

12. The system of claim 11 wherein said fluid outlet 18 is adapted to be placed in fluid communication with a combustion chamber of a diesel engine and said diesel fuel is passed to said diesel engine after passing through said cooling unit 10.

13. The system of claim 9 wherein said elongated body portion 12 is made of extruded aluminum.

14. The system of claim 9 wherein said elongated body portion 12 is about 10 to about 100 centimeters in length.

15. The system of claim 9 wherein said fluid channel 14 has an overall cross-sectional diameter of about 10 to about 40 millimeters.

16. The system of claim 9 wherein said fluid channel 14 has a thickness of about 1 to about 30 millimeters.

17. A method for cooling a heated substrate 20 comprising the steps of:
providing a cooling unit 10 having an elongated fluid channel 14 extending therethrough, wherein said fluid channel 14 includes at least one of a generally G-shaped cross-section, a generally C-shaped cross-section and a generally ( )-shaped cross-section;
contacting said cooling unit 10 to a substrate 20; and
passing a cooling fluid through said fluid channel 14 to cool said substrate 20.

18. The method of claim 17 wherein said passing step is performed at a low flow rate.

19. The method of claim 17 wherein said cooling fluid is a fuel.

20. The method of claim 19 further comprising the step of passing said fuel to a combustion chamber of an engine after said fuel passes through said fluid channel 14.
